(19) Europäisches Patentamt
European Patent Office
Office européen des brevets

(11) Publication number: **0 176 818 B1**

## (12) EUROPEAN PATENT SPECIFICATION

(45) Date of publication of patent specification: **29.05.91**   (51) Int. Cl.⁵: **H03L 1/02**

(21) Application number: **85111409.0**

(22) Date of filing: **09.09.85**

(54) **Temperature-compensated oscillation device.**

(30) Priority: **10.09.84 JP 189138/84**

(43) Date of publication of application:
**09.04.86 Bulletin 86/15**

(45) Publication of the grant of the patent:
**29.05.91 Bulletin 91/22**

(84) Designated Contracting States:
**DE FR GB SE**

(56) References cited:
**DE-A- 2 936 378**
**FR-A- 2 457 606**
**US-A- 3 719 838**

(73) Proprietor: **NEC CORPORATION**
**7-1, Shiba 5-chome Minato-ku**
**Tokyo 108-01(JP)**

(72) Inventor: **Fukumura, Yukio**
**c/o NEC Corporation 33-1, Shiba 5-chome**
**Minato-ku Tokyo(JP)**
Inventor: **Matsuura, Takashi**
**c/o NEC Corporation 33-1, Shiba 5-chome**
**Minato-ku Tokyo(JP)**

(74) Representative: **Vossius & Partner**
**Siebertstrasse 4 P.O. Box 86 07 67**
**W-8000 München 86(DE)**

## Description

The present invention relates to a temperature-compensated oscillation device and, more particularly, to a digitally controlled temperature-compensated oscillation device.

A digitally controlled temperature-compensated oscillation device has been extensively used as a local oscillator of a mobile radio apparatus because its frequency generally remains stable over a wide temperature range. Such a type of oscillation device comprises a temperature sensing section made up of a temperature sensor and an analog-to-digital (A/D) converter, a read only memory (ROM) which stores compensation data associated with outputs of the A/D converter, and an oscillating section responsive to an output of the ROM and made up of a digital-to-analog (D/A) converter and a voltage controlled oscillator (VCO).

The problem with an oscillation device having the above construction is that a noticeable variation in ambient temperature causes an output of the A/D converter, i.e., an output value of the ROM, to sharply vary for a moment to thereby add frequency modulation noise and phase modulation noise to an output of the VCO. Such, in a multichannel communication system, constitutes a source of noise for other channels or needs to be coped with by designing the exclusive frequency band undesirably wide .

DE-A- 29 36 378 discloses a device for compensating the frequency/temperature relation of a crystal oscillator in an oscillator circuit. The device is provided with a capacitance diode which fine-tunes the frequency of the crystal oscillator in dependence of the voltage applied to said diode. The fine tuning voltage does not change continuously in dependence of the temperature. but abruptly in predetermined temperature intervals.

It is an object of the present invention to provide a digitally controlled temperature-compensated oscillation device which reduces the previously mentioned kinds of noise.

This object is achieved by the oscillator device according to the claims.

The above and other objects, features and advantages of the present invention will become more apparent from the following detailed description taken with the accompanying drawings in which:

Fig. 1 is a block diagram of a prior art temperature-compensated oscillation device;

Figs. 2A - 2C are graphs representative of the operation of a voltage-controlled oscillator applicable to the present invention as well as to the prior art, specifically Fig. 2A showing an oscillation signal frequency variation against ambient temperature characteristic, Fig. 2B an oscillation signal frequency variation against frequency control signal characteristic, and Fig. 2C a frequency control signal against ambient temperature characteristic;

Fig. 3 is a graph showing an oscillation signal frequency variation against ambient temperature characteristic of a prior art temperature-compensated oscillation device and that of the present invention;

Fig. 4 is a graph showing an oscillation signal frequency variation against time characteristic of the prior art temperature-compensated oscillation device;

Fig. 5 is a block diagram of a temperature-compensated oscillation device embodying the present invention;

Fig. 6 is an oscillation signal frequency variation against time characteristic particular to the temperature-compensated oscillation device of the present invention; and

Fig. 7 is a block diagram showing another embodiment of the present invention.

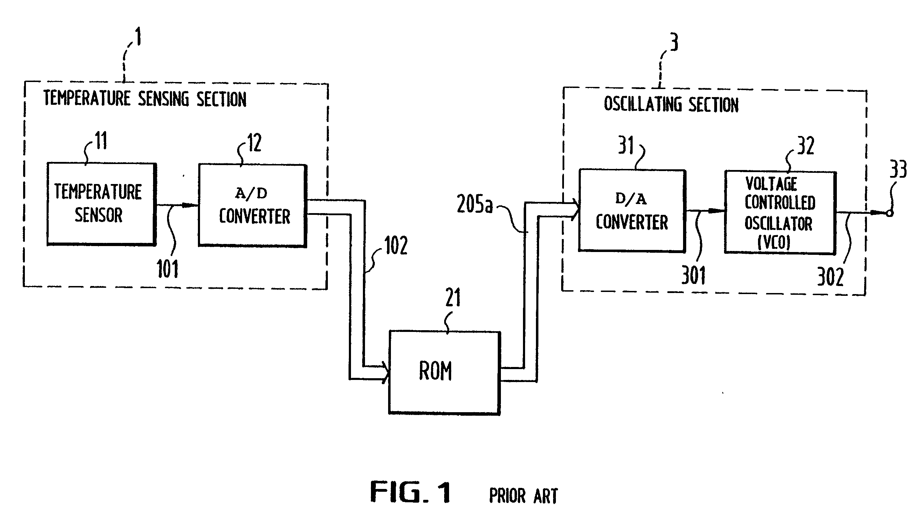

To better understand the present invention, a brief reference will be made to a prior art digitally controlled oscillation device, shown in Fig. 1. As shown, the device comprises a temperature sensing section 1 made up of a temperature sensor 11 and an analog-to-digital (A/D) converter 12, a read only memory (ROM) 21, and an oscillating section 3 made up of a digital-to-analog (D/A) converter 31 and a voltage-controlled oscillator (VCO) 32. The VCO 32 comprises a crystal oscillator and a variable capacitance element. The temperature sensor 11 senses an ambient temperature to convert it to a voltage which is applied as a temperature data signal 101 to the A/D converter 12. The A/D converter 12 quantizes the input signal 101 to provide a first digital value which is produced as a first digital signal 102. This signal 102 is delivered to an address input terminal of the ROM 21 so as to specify a particular address of the latter, whereby a second digital value stored in that address is outputted as a second digital signal 205a. The D/A converter 31 to which the second digital signal 205a is routed transforms the signal 205a into a voltage and applies the voltage as a frequency control signal 301 to the VCO 32. Responsive to the signal 301, the VCO 32 controls the capacitance of its variable capacitance element and, as a result, temperature-compensates the frequency of an oscillation signal 302, which is an output of the VCO 32.

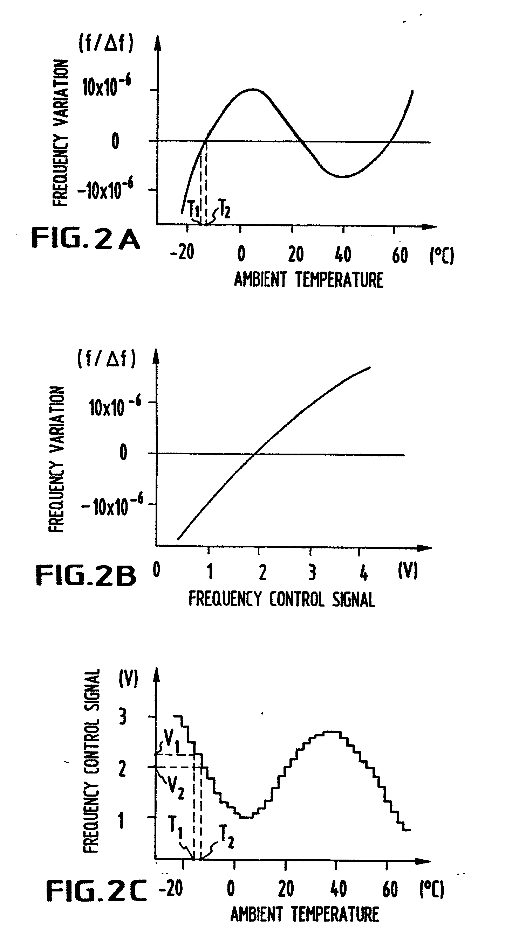

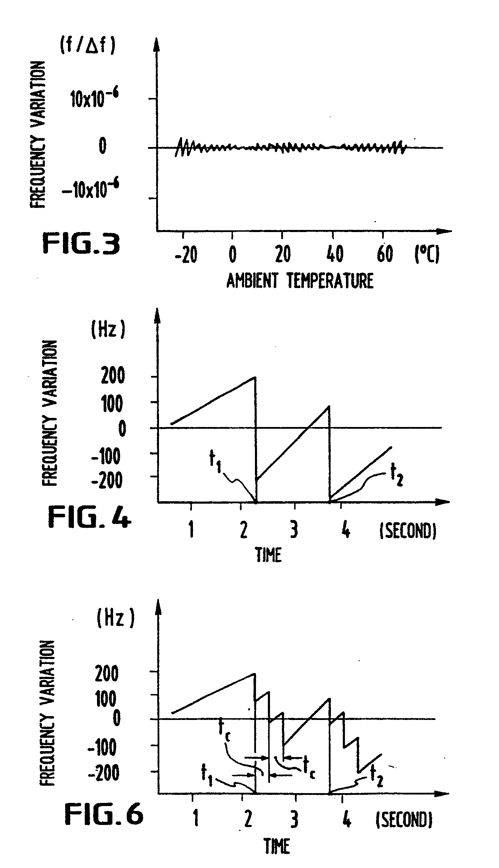

Details of the temperature compensation effected as above will be described with reference to Figs. 2A - 2C. While the frequency control signal 301 is maintained at a certaian constant value, the frequency of the oscillation signal 302 may vary with the ambient temperature as shown in Fig. 2A. Specifically, the graph represents a relationship between the temperature surrounding the crystal oscillator of the VCO 32 and the variation of its resonance frequency. Meanwhile, when the ambient temperature remains constant, the frequency of the oscillation signal 302 may vary with the frequency control signal 301 as shown in Fig. 2B. If the relationship between the first digital signal 102 and the second digital signal 205a in the ROM 21 is selected such that the relationship shown in Fig. 2C holds between the ambient temperature and the frequency control signal 301, the frequency of the oscillation signal 302 will be temperature-compensated. The curve shown in Fig. 2C is stepwise because the ambient temperature is quantized as the first digital signal 102. The frequency variation of the oscillation signal 302 after temperature compensation is shown in Fig. 3 relative to the ambient temperature. Comparing Fig. 3 with Fig. 2A, it will be seen that as a result of temperature compensation the frequency variation of the oscillation signal 302 has been reduced to about 1/4 over the temperature range of $-20^\circ$C to $+60^\circ$C.

Referring to Fig. 4, there is shown a graph representative of exemplary frequency variations of the oscillation signal 302 with respect to time which occur while the ambient temperature is varied with time. As understood by comparing Fig. 4 With Figs. 2A and 2C, the ambient temperature as shown in Fig. 4 is assumed to increase with time and a temperature $T_1$ is associated with a time $t_1$ and a temperature $T_2$ with a time $t_2$. During the period between the times $t_1$ and $t_2$, the frequency control signal 301 remains at a constant voltage $V_1$ and the frequency of the oscillation signal 302 increases with time. At the time $t_2$, the signal 301 shifts from the voltage $V_1$ to a voltage $V_2$ and, at this moment, the frequency of the signal 302 is sharply lowered. In this manner, at the moment when the output of the A/D converter is varied, the frequency of the oscillation signal 302 is sharply varied with the result that frequency modulation noise and phase modulation noise are added to the signal 302.

Thus, the digitally temperature-controlled oscillation device installed in a radio frequency or phase modulation communication system is sufficiently small in frequency variation, but cannot avoid a substantial magnitude of noise as previously discussed. In addition, the influence of noise extends even to other channels.

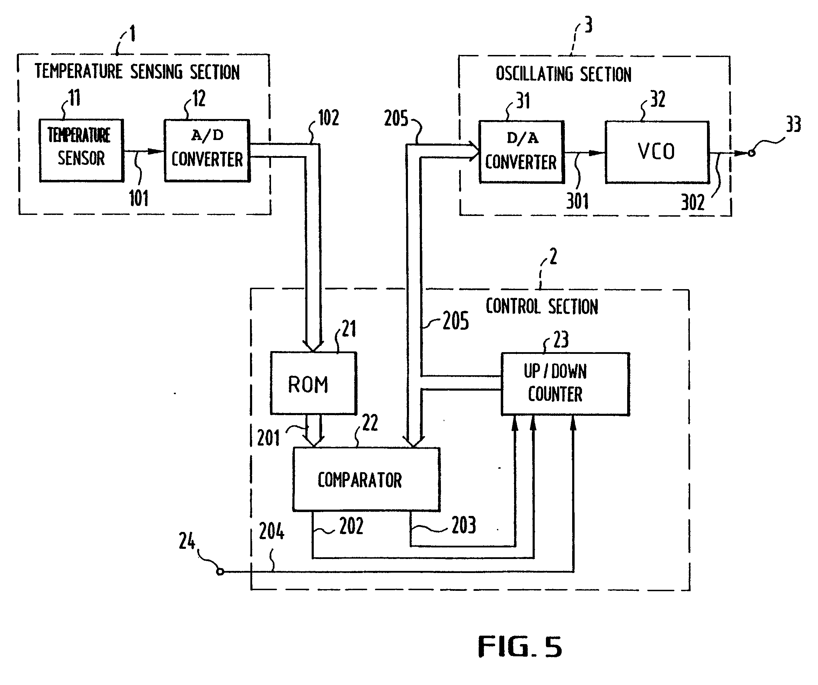

Referring to Fig. 5, a temperature-compensated oscillation device embodying the present invention is shown which is free from the drawbacks stated above. As shown, the oscillation device comprises a temperature sensing section 1 which includes a temperature sensor 11 and an A/D converter 12, a control section 2 made up a ROM 21, a comparator 22 and an up-down counter 23, and an oscillating section 3 made up of a D/A converter 31 and a VCO 32. The VCO 32 comprises a crystal oscillator and a variable capacitance element. The temperature sensor 11 converts an ambient temperature to a voltage and produces the voltage as a temperature data signal 101. Responsive to the signal 101, the A/D converter 12 quantizes it to provide a first digital value and applies the first digital value as a first digital signal 102 to an address input terminal of the ROM 21. The ROM 21 produces a third digital value (assumed to have a value A) from a particular address thereof which is specified by the input signal 102, the third digital value being applied to one input terminal of the comparator 22. Applied to the other input terminal of the comparator 22 is a count from the up-down counter 23 (assumed to have a value B). The comparator 22 produces an identification signal 202 which is a high level "1" when A = B and a low level "0" when A ≠ B. The comparator 22 also produces a discrimination signal 203 which is a high level "1" when A > B and a low level "0" when A < B. The identification signal 202 and the discrimination signal 203 are applied to the up-down counter 23. A clock signal 204 is also applied to the up-down counter 23 via a clock input terminal 24 of the control section 2. While the identification signal 202 is a high level, the counter 23 is disenabled to maintain the value B equal to the value A. While the identification signal 202 is a low level and the discrimination signal 203 is a high level, the counter 23 is incremented responsive to each pulse of the clock signal 204. When the identification signal 202 is a low level and the discrimination signal 203 is a high level, the counter 23 is decremented responsive to each pulse of the clock signal 204. In this manner, the comparator 22 and the counter 23 cooperate with each other to maintain the value B equal to the value A when A = B and to increment or decrement the value B to the value A when A ≠ B. The output 205 of the counter 23 is also applied to the D/A converter 31. The D/A converter 31 converts the input signal 205 to a voltage and applies it to the VCO 301 as a frequency control signal 301. The signal 301 controls the capacitance of the variable capacitance element of the VCO 301 to thereby temperature-compensate the frequency of an oscillation signal 302 which is outputted from the oscillation device.

Thus, the control section 2 converts a variation in the first digital signal 102 to a plurality of time-divided fractional variations in the output 205 of the counter 23.

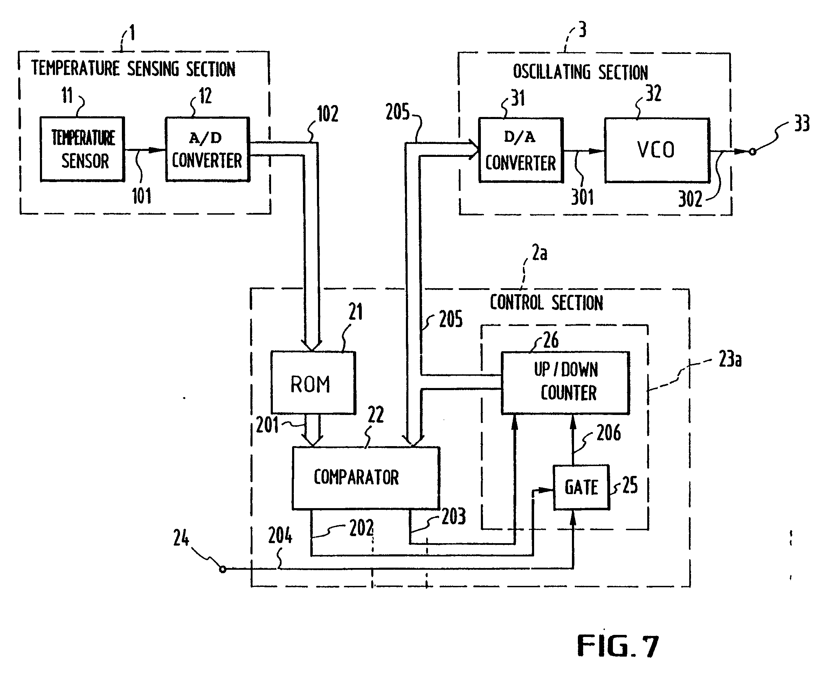

Referring to Fig. 6, an exemplary relationship between time and the frequency variation of the oscillation signal 302 in accordance with the illustrative embodiment is shown, the temperature being assumed as varying with time. Assume that a value A associated with an ambient temperature at a time immediately before a time $t_1$ is $A_1$, and that the value $A_1$ has changed to $A_2$ at the time $t_1$. Then, the value B changes from $A_1$ to $(A_1 - 1)$ at the time $t_1$, to $(A_1 - 2)$ at a time $(t_1 + t_c)$, and to $(A_1 - 3)$ at a time $(t_1 + 2t_c)$, where $t_c$ is the period of the clock signal 204. In the example shown in Fig. 6, $A_2$ is equal to $(A_1 - 3)$. As the value B is varied at the times $t_1$, $(t_1 + t_c)$ and $(t_1 + 2t_c)$, the frequency of the oscillation signal 302 is also varied in a stepwise manner at those times. Comparing Fig. 6 with Fig. 4, it will be apparent that the stepwise variations, i.e., the amounts of sharp variations of the frequency of the signal 302 are smaller in the illustrative embodiment than in the prior art and, as a result, noise introduced into the signal 302 due to the sharp frequency variations is reduced.

Referring to Fig. 7, another embodiment of the present invention is shown. The oscillation device in this particular embodiment differs from that of Fig. 5 in that the up-down counter 23 of the latter is replaced with a gate 25 and an up-down counter 26, and in that the identification signal 202 and clock signal 204 are applied to the gate 25. Specifically, when the identification signal 202 is a low level, the gate 25 is enabled to pass the clock signal 204 to the up-down counter 26 as an output signal 206. When the signal 202 is a high level, the gate 25 is disenabled to interrupt the supply of the clock signal 204 to the counter 26. The gate 25 and the counter 26 cooperates, as labeled 23a in the drawing, to fulfill the function which is assigned to the counter 23 of the first embodiment. Hence, the embodiment of Fig. 7 is the same in operation and effect as the embodiment of Fig. 5.

In summary, it will be seen that the present invention provides a temperature-compensated oscillation device which reduces frequency variations and noise over a wide temperature range. Hence, a radio communication apparatus implemented with such a device of the present invention will narrow the exclusive frequency band width, compared to a prior art apparatus.

Various modifications will become possible for those skilled in the art after receiving the teachings of the present disclosure without departing from the scope thereof. For example, while ROM 21 is used in the illustrative embodiments to serve the function of numerical value conversion means for converting the first digital signal 102 to the third digital signal 201, such a function may alternatively be fulfilled by means of a memory which generates a constant of a polynominal for converting a first digital value to a second digital value and an operation unit for operating the polynomial. Such a kind of conversion means is disclosed in JP-A-58-184809, for example. Further, in the illustrative embodiments as well as in the modification mentioned above, the crystal oscillator included in the VCO 32 may be replaced with an elastic surface wave element. In addition, in all the embodiments and their modifications described, the clock signal input terminal 24 may be omitted and, instead, a clock signal generator may be added to the control section 2, in which case the output of the clock signal generator will serve as the clock signal 204.

## Claims

1. A temperature-compensated oscillator device comprising:

    temperature sensing section means (1) including temperature sensor means (11) for sensing an ambient temperature to provide a temperature data signal (101) representative of the sensed temperature and analog-to-digital converter means (12) for converting the temperature data signal (101) to a first digital signal (102) having a first digital value;

    control section means (2) for converting the first digital signal (102) to a second digital signal (205) having a second digital value; and

    oscillating section means (3) including converter means (31) for converting the second digital signal (205) to a frequency control signal (301) and voltage-controlled oscillator means (32) responsive to the frequency control signal (301) for changing the oscillation signal frequency thereof;

    characterized in that

    the control section means (2) comprises first means (21) responsive to the first digital signal (102) for providing a third digital signal (201) corresponding thereto;

    second means (22) for comparing the second digital signal (205) with the third digital signal (201) and providing an identification signal (202) indicative of whether the second (205) and third digital signals (201) are coincident with each other and a discrimination signal (203) indicative of which one of the second (205) and third digital signals (201) is greater than the other and

    third means (23) responsive to the identification signal (202), the discrimination signal (203) and a clock signal (204) for, when the identification signal (202) indicates coincidence, stopping a count of the clock signal (204) and, when the identification signal (202) indicates non-coincidence, incrementing or decrementing the count in accordance with the discrimination signal (203), thereby providing the second digital signal (205).

2. A temperature-compensated oscillator device as claimed in Claim 1, wherein the first means (21) comprises a read only memory (21), the second means (22) comprises a digital comparator (22) and the third means (23) comprises an up/down counter (26).

3. A temperature-compensated oscillator device comprising:
temperature sensing section means (1) including temperature sensor means (11) or sensing an ambient temperature to provide a temperature data signal (101) representative of the sensed temperature and analog-to-digital converter means (12) for converting the temperature data signal (101) to a first digital signal (102) having a first digital value;
control section means (2) for converting the first digital signal (102) to a second digital signal (205) having a second digital value; and oscillating section (3) means including converter means (31) for converting the second digital signal (205) to a frequency control signal (301) and voltage-controlled oscillator means (32) responsive to the frequency control signal (301) for changing the oscillation signal frequency thereof;
characterized in that
the control section means (2) comprises first means (21) responsive to the first digital signal (102) for providing a third digital signal (201) corresponding thereto;
second means (22) for comparing the second digital signal (205) with the third digital signal (201) and providing an identification signal (202) indicative of whether the second (205) and third digital signals (201) are coincident with each other and a discrimination signal (203) indicative of which one of the second (205) and third digital signals (201) is greater than the other;
third means (25) for controlling the passing of a clock signal (204) according to the identification signal (202) and
fourth means (26) for counting the output (206) of the third means (25) according to the discrimination signal (203).

4. A temperature-compensated oscillator device as claimed in Claim 3, wherein the first means (21) comprises a read only memory (21), the second means (22) comprises a digital comparator (22), the third means (25) comprises a gate circuit (25) and the fourth means (26) comprises an up/down counter (26).

**Revendications**

1. Dispositif oscillateur compensé en température comprenant :
- un moyen de partie de détection de température (1) incluant un moyen de détecteur de température (11) pour détecter la température ambiante afin de produire un signal de donnée de température (101) représentatif de la température détectée et un moyen de convertisseur analogique/numérique (12) pour convertir le signal de donnée de température (101) en un premier signal numérique (102) ayant une première valeur numérique;
- un moyen de partie de contrôle (2) pour convertir le premier signal numérique (102) en un second signal numérique (205) ayant une seconde valeur numérique;
- et un moyen de partie oscillateur (3) incluant un moyen de convertisseur (31) pour convertir le deuxième signal numérique (205) en un signal de contrôle de fréquence (301) et un moyen d'oscillateur contrôlé en tension (32), répondant au signal de contrôle de fréquence (301), pour changer la fréquence du signal d'oscillateur de celui-ci; caractérisé en ce que :
- le moyen de partie de contrôle (2) comprend un premier moyen (21), répondant au premier signal numérique (102), pour fournir un troisième signal numérique (201) correspondant à celui-ci;
- un second moyen (22) pour comparer le deuxième signal numérique (205) et le troisième signal numérique (201) et fournir un signal d'identification (202) qui indique que les deuxième (205) et troisième (201) signaux numériques coïncident l'un avec l'autre et fournir un signal de discrimination (203) qui indique lequel des deuxième (205) et troisième (201) signaux numériques est plus grand que l'autre, et
- un troisième moyen (23) répondant au signal d'identification (202), au signal de discrimination (203) et à un signal d'horloge (204) pour, quand le signal d'identification (202) indique la coïncidence, arrêter le comptage du signal d'horloge (204) et pour, quand le signal d'identification (202) indique la non-coïncidence, incrémenter ou décrémenter le comptage en accord avec le signal de discrimination (203), et par là fournir le second signal numérique (205).

2. Dispositif oscillateur compensé en température selon la revendication 1, où le premier moyen (21) comprend une mémoire morte (21), le second moyen (22) comprend un comparateur numérique (22) et le troisième moyen (23) comprend un compteur progressif/régressif (26).

3. Dispositif oscillateur compensé en température comprenant :

- un moyen de partie de détection de la température (1) incluant un moyen de détecteur de température (11) pour détecter la température ambiante afin de fournir un signal de donnée de température (101) représentatif de la température détectée et un moyen de convertisseur analogique/numérique (12) pour convertir le signal de donnée de température (101) en un premier signal numérique (102) ayant une première valeur numérique; un moyen de partie de contrôle (2) pour convertir le premier signal numérique (102) en un second signal numérique (205) ayant une seconde valeur numérique; et un moyen de partie oscillateur (3) incluant un moyen de convertisseur (31) pour convertir le deuxième signal numérique (205) en un signal de contrôle de fréquence (301) et un moyen d'oscillateur contrôlé en tension (32), répondant au signal de contrôle de fréquence (301), pour changer la fréquence du signal d'oscillation de celui-ci; caractérisé en ce que :

- le moyen de partie de contrôle (2) comprend un premier moyen (21), répondant au premier signal numérique (102), pour fournir un troisième signal numérique (201) correspondant à celui-ci;

- un deuxième moyen (22) pour comparer le deuxième signal numérique (205) au troisième signal numérique (201) et fournir un signal d'identification (202) qui indique que les second (205) et troisième (201) signaux numériques coïncident ou non l'un avec l'autre et un signal de discrimination (203) qui indique lequel des second (205) ou troisième (201) signaux numériques est plus grand que l'autre;

- un troisième moyen (25) pour contrôler le passage d'un signal d'horloge (204) en conformité avec le signal d'identification (202); et

- un quatrième moyen (26) pour compter la sortie (206) du troisième moyen (25) selon le signal de discrimination (203).

4. Dispositif oscillateur compensé en température selon la revendication 3, où le premier moyen (21) comprend une mémoire morte (21), le second moyen (22) comprend un comparateur numérique (22), le troisième moyen (25) comprend un circuit à porte (25) et le quatrième moyen (26) comprend un compteur progressif/régressif (26).

## Ansprüche

1. Temperaturkompensierte Oszillatorvorrichtung mit:

einer Temperaturfühlteileinrichtung (1), die eine Temperaturfühleinrichtung (11) zum Fühlen einer Umgebungstemperatur, um ein der gefühlten Temperatur entsprechendes Temperaturdatensignal (101) bereitzustellen, und eine Analog-Digital-Umsetzereinrichtung (12) zum Umsetzen des Temperaturdatensignals (101) in ein erstes Digitalsignal (102) mit einem ersten Digitalwert enthält,

einer Regelteileinrichtung (2) zum Umsetzen des ersten Digitalsignals (102) in ein zweites Digitalsignal (205) mit einem zweiten Digitalwert, und

einer Oszillierteileinrichtung (3), die eine Umsetzereinrichtung (31) zum Umsetzen des zweiten Digitalsignals (205) in ein Frequenzsteuersignal (301) und eine spannungsgeregelte Oszillatoreinrichtung (32) enthält, die auf das Frequenzsteuersignal (301) reagiert und die Oszillationssignalfrequenz ändert,

dadurch gekennzeichnet, daß die Regelteileinrichtung (2) aufweist:

eine erste Einrichtung (21), die auf das erste Digitalsignal (102) reagiert und ein entsprechendes drittes Digitalsignal (201) bereitstellt,

eine zweite Einrichtung (22) zum Vergleichen des zweiten Digitalsignals (205) mit dem dritten Digitalsignal (201) und Bereitstellen eines Kennzeichnungssignals (202), das anzeigt, ob das zweite (205) und dritte Digitalsignal (201) miteinander übereinstimmen, und eines Unterscheidungssignals (203), das anzeigt, ob das zweite (205) oder das dritte Digitalsignal (201) größer ist als das jeweils andere Signal, und

eine dritte Einrichtung (23), die auf das Kennzeichnungssignal (202), das Unterscheidungssignal (203) und ein Taktsignal (204) reagiert, um, wenn das Kennzeichnungssignal (202) Übereinstimmung anzeigt, ein Zählen des Taktsignals (204) einzustellen und, wenn das Kennzeichnungssignal (202) Nicht-Übereinstimmung anzeigt, das Zählen entsprechend dem Unterscheidungssignal (203) schrittweise zu erhöhen oder zu verringern und dadurch das zweite Digitalsignal (205) bereitzustellen.

2. Temperaturkompensierte Oszillatorvorrichtung nach Anspruch 1, wobei die erste Einrichtung (21) einen Nurlesespeicher (21), die zweite Einrichtung (22) einen Digitalvergleicher (22) und die dritte Einrichtung (23) eine Auf/Ab-Zähleinrichtung (26) aufweist.

3. Temperaturkompensierte Oszillatorvorrichtung mit:

einer Temperaturfühlteileinrichtung (1), die eine Temperaturfühleinrichtung (11) zum Fühlen einer Umgebungstemperatur, um ein der gefühlten Temperatur entsprechendes Temperaturdatensignal (101) bereitzustellen, und eine Analog-Digital-Umsetzereinrichtung (12) zum Umsetzen des Temperaturdatensignals (101) in ein erstes Digitalsignal (102) mit einem ersten Digitalwert enthält,

einer Regelteileinrichtung (2) zum Umsetzen des ersten Digitalsignals (102) in ein zweites Digitalsignal (205) mit einem zweiten Digitalwert, und

einer Oszillierteileinrichtung (3), die eine Umsetzereinrichtung (31) zum Umsetzen des zweiten Digitalsignals (205) in ein Frequenzsteuersignal (301) und eine spannungsgeregelte Oszillatoreinrichtung (32) enthält, die auf das Frequenzsteuersignal (301) reagiert und die Oszillationssignalfrequenz ändert,

dadurch gekennzeichnet, daß die Regelteileinrichtung (2) aufweist:

eine erste Einrichtung (21), die auf das erste Digitalsignal (102) reagiert und ein entsprechendes drittes Digitalsignal (205) bereitstellt,

eine zweite Einrichtung (22) zum Vergleichen des zweiten Digitalsignals (205) mit dem dritten Digitalsignal (201) und Bereitstellen eines Kennzeichnungssignals (202), das anzeigt, ob das zweite (205) und dritte Digitalsignal (201) miteinander übereinstimmen, und eines Unterscheidungssignals (203), das anzeigt, ob das zweite (205) oder das dritte Digitalsignal (201) größer ist als das jeweils andere Signal,

eine dritte Einrichtung (25) zum Steuern des Durchgangs eines Taktsignals (204) entsprechend dem Kennzeichnungssignal (202), und

eine vierte Einrichtung (26) zum Zählen der Ausgabe (206) der dritten Einrichtung (25) entsprechend dem Unterscheidungssignal (203).

4. Temperaturkompensierte Oszillatoreinrichtung nach Anspruch 3, wobei die erste Einrichtung (21) einen Nurlesespeicher (21), die zweite Einrichtung (22) einen Digitalvergleicher (22), die dritte Einrichtung (25) eine Gatterschaltung (25) und die vierte Einrichtung (26) eine Auf/Ab-Zähleinrichtung aufweist.

FIG. 1  PRIOR ART

Figure labels: OSCILLATING SECTION; TEMPERATURE SENSING SECTION; D/A CONVERTER (31, 301); VOLTAGE CONTROLLED OSCILLATOR (VCO) (32, 302); 33; 3; 205a; ROM (21); 102; A/D CONVERTER (12); TEMPERATURE SENSOR (11, 101); 1

FIG.2A

FREQUENCY VARIATION $(f/\Delta f)$

$10\times10^{-6}$

$0$

$-10\times10^{-6}$

$T_1$ $T_2$

-20  0  20  40  60  (°C)

AMBIENT TEMPERATURE

FIG.2B

FREQUENCY VARIATION $(f/\Delta f)$

$10\times10^{-6}$

$0$

$-10\times10^{-6}$

0  1  2  3  4  (V)

FREQUENCY CONTROL SIGNAL

FIG.2C

FREQUENCY CONTROL SIGNAL (V)

3

$V_1$

2

$V_2$

1

$T_1$  $T_2$

-20  0  20  40  60  (°C)

AMBIENT TEMPERATURE

FIG.3

FIG. 4

FIG.6

FIG. 5

FIG. 7